# EUROPEAN PATENT SPECIFICATION

(11) **EP 3 529 823 B1**
(45) Date of publication and mention of the grant of the patent: **19.05.2021**
(21) Application number: 17790674.0
(22) Date of filing: 24.10.2017
(51) Int. Cl.: H01J 37/26, H01J 37/22, H01J 37/04

(54) **CHARGED-PARTICLE MONITORING APPARATUS, ELECTRON MICROSCOPE AND METHOD FOR DETECTION OF CHARGED-PARTICLES**
ÜBERWACHUNGSVORRICHTUNG FÜR GELADENE TEILCHEN, ELEKTRONENMIKROSKOP UND VERFAHREN ZUR DETEKTION VON GELADENEN TEILCHEN
APPAREIL DE SURVEILLANCE DE PARTICULES CHARGÉES, MICROSCOPE ÉLECTRONIQUE ET PROCÉDÉ DE DÉTECTION DE PARTICULES CHARGÉES

(30) Priority: 24.10.2016 DE 102016012724
(43) Date of publication of application: 28.08.2019
(73) Proprietor: Baum, Peter, 82166 Gräfelfing (DE)
(72) Inventor: Baum, Peter, 82166 Gräfelfing (DE)
(74) Representative: Schatt, Markus F.
(86) International application number: PCT/EP2017/001242
(87) International publication number: WO 2018/077471

(56) References cited:
- US-A1- 2010 108 882
- A. RYABOV ET AL: "Electron microscopy of electromagnetic waveforms", SCIENCE, vol. 353, no. 6297, 22 July 2016 (2016-07-22), pages 374-377, XP055439510, ISSN: 0036-8075, DOI: 10.1126/science.aaf8589
- C. KEALHOFER ET AL: "All-optical control and metrology of electron pulses", SCIENCE, vol. 352, no. 6284, 22 April 2016 (2016-04-22), pages 429-433, XP055439523, ISSN: 0036-8075, DOI: 10.1126/science.aae0003 cited in the application
- GREIG S R ET AL: "On the role of terahertz field acceleration and beaming of surface plasmon generated ultrashort electron pulses", APPLIED PHYSICS LETTERS, A I P PUBLISHING LLC, US, vol. 105, no. 4, 28 July 2014 (2014-07-28) , XP012188096, ISSN: 0003-6951, DOI: 10.1063/1.4891825 [retrieved on 1901-01-01]

## Description

The present invention relates to a charged-particle monitoring apparatus, an electron microscope and a method for detection of charged-particles.

Optics at sub-wavelength dimensions, a field called nanophotonics, is currently revolutionizing ultrafast information processing and communication, because the approach unites the nanometer-scale device dimensions needed for miniaturization with the ultimate computation speed offered by the frequency of light (10.000 times that in electronics). Since modern nanofabrication techniques allow creating almost any shape with a large freedom in design, nanophotonic elements offer an almost unrestricted control of light waves for optical or information processing applications. For example in metamaterials, which are artificial nanoscale antenna arrays, some optical effects can be produced that are otherwise entirely impossible to achieve, for example cloaking layers, lensless imaging devices or negative-refractive-index materials.

However, before the ultimate potential of nanophotonics can be realized, a method is required to actually characterize the local electromagnetic function of fabricated devices in real time. The relevant processes take place at length and time scales much shorter than the period (usually on the order of 0.3-30 fs) and wavelength (usually on the order of 0.1-10 µm) of light. The physical quantity to study is the electromagnetic field in space and time. The required imaging resolutions are close-to-atomic in space (nanometers) and sub-light-cycle in time (femtoseconds to attoseconds).

Ideal would in addition be a visualization of the field vector directions and polarization dynamics.

Unfortunately, this combination is currently out of reach, although it would enable the guided design of novel optical and nanophotonic devices for optical and information processing purposes.

Electron microscopes can provide a spatial resolution of about 10⁻¹⁰ m, but their temporal resolution is far from sufficient for measurements of lightwave dynamics.

A conventional approach combining the high spatial resolution with time resolution is disclosed in DE 10 2012 112 995 A1. The document suggests modulating an electron acceleration voltage to modulate the energy of a continuous electron beam and image detection after an imaging energy analyzer. The effective temporal resolution is given by the inverse of the modulation frequency and does not reach the temporal resolution desired for studying lightwave phenomena at a sample. Electron sources in electron microscopes are millimeters to centimeters in size and therefore have an electric capacity that unavoidably limits the maximum electric modulation frequency to the microwave regime (tens of GHz), which is 10000 times slower than desired.

A further conventional system is disclosed in US 2016/0005567 A1. Electron pulses are generated by directing temporally-shaped nanosecond laser pulses onto a photocathode thus yielding pulses including 107 to 109 electrons per pulse for electron diffraction or microscopy. Providing high spatial resolution, such system can however only provide a temporal resolution which is on the order of nanoseconds, which is about a million times slower than desired.

A better time resolution can be achieved with so called "ultrafast electron microscopes", where a femtosecond laser is used to trigger electron emission from a photocathode. Femtosecond electron pulses can thus be produced that are synchronous with the laser pulses. Time-dependent images can therefore be obtained with a pump-probe approach, for example by varying the delay between excitation and probing. A typical example in this respect is disclosed in WO 2011/146084 A1. Even though providing improved temporal resolution of down to 300 fs, the achieved resolution is still not sufficient to study optical phenomena at lightwave frequency, which oscillates 100-1000 times faster.

In order to further decrease the electron pulse duration and thus increase the temporal resolution, methods have been proposed for compressing the laser-generated electron pulses in time to increase temporal resolution. For example, the publication "All-optical control and metrology of electron pulses", C. Kealhofer et al., Science 352, 6284, April 22, 2016, co-authored by the present inventor, suggests an approach according to which femtosecond electron pulses generated by femtosecond laser photoemission can be further compressed in time with optically generated terahertz radiation pulses. A metal foil or microstructure resonator serves as interaction region for the pulse compression. The experimental results reach an electron pulse duration of as short as 75 fs.

A further scientific publication, "Electron microscopy of electromagnetic waveforms", A. Ryabov and P. Baum, Science 353, 6297, July 22, 2016, this publication also being co-authored by the present inventor, is a further example of a femtosecond-laser based system.

A femtosecond laser produces terahertz pulses and a train of femtosecond electron pulses using a conventional photo cathode. The terahertz pulses are used for compression of the (probe-) electron pulses and in addition to trigger resonance (pump pulses) in a micro-fabricated sample. Thus using a pump-probe approach by shifting the compressed electron pulses (probe pulses) with respect to the terahertz pulses used for triggering the resonance (pump pulses), the temporal and spatial evolution of electric fields at the sample can be monitored, but only at terahertz frequencies, which are about a thousand times slower than the oscillations of light.

Thus, even though the best devices presently available in terms of spatial and temporal resolution, i.e. femtosecond laser based ultrafast electron monitoring apparatuses, already reach femtosecond temporal resolution, these apparatuses still do not reach the desired temporal resolution for example for actually characterizing local electromagnetic functions e.g. of nano-fabricated devices or other materials/substances with optical effects in real time.

It is thus an object of the present invention to provide a charged-particle monitoring apparatus, preferably an electron monitoring apparatus such as an electron microscope, and a method for detection of charged-particles which respectively allows further reducing the temporal resolution.

Particularly, an object of the present invention is to provide a charged-particle monitoring apparatus, preferably an electron monitoring apparatus such as an electron microscope, and a method for detection of charged-particles, which respectively allows further reducing the temporal resolution into the few-femtosecond and attosecond regime, while the system maintains a spatial resolution within the regime e.g. of currently available electron microscopes.

This and other objects are solved by a charged-particle monitoring apparatus according to claim 1 and by an independent method as claim. Further embodiments are described in respective dependent claims.

According to the invention, a charged-particle monitoring apparatus is provided for time-resolved monitoring of ultrafast processes, i.e. processes with sub-picosecond, preferably sub-femtosecond dynamics. In other words, the apparatus according to the present invention is preferably provided with a time resolution sufficient for time-resolved monitoring of processes with sub-picosecond, preferably sub-femtosecond time constants or dynamics. Comprising the said features, the apparatus can also be used for monitoring of slower processes, or parts of such slower processes, and even for imaging of static objects.

However, being able to provide such high temporal resolution, the charged-particle monitoring apparatus can preferably be used for example for monitoring local electromagnetic functions of nano-fabricated devices or other materials/substances in space and real time at optical frequencies.

According to the present invention a charged-particle monitoring apparatus, preferably an electron monitoring apparatus such as an electron microscope, is provided, which allows further reducing the temporal resolution preferably into the few-femtosecond and attosecond regime, particularly while the system maintains a spatial resolution within the regime e.g. of currently available electron microscopes.

According to the invention, the charged-particle monitoring apparatus comprises a charged-particle source which can be an essentially continuous, preferably continuous, charged-particle source. The charged-particle source is adapted to emit a beam of charged particles along a main beam axis which can be an at least partially continuous beam of charged particles, preferably a continuous beam, along a main beam axis. In a preferred embodiment, the charged particles are electrons. The charged-particle beam thus travels along the main beam axis. Under normal circumstances, this path of charged-particle beam propagation is essentially straight. Depending on the circumstances this path may also be curved e.g. due to the presence of electromagnetic or gravitational fields caused by the environment or by charged particle optics elements.

In an embodiment, the charged-particle source is a continuous charged-particle source such as a continuous electron source, i.e. a source adapted to emit a continuous charged-particle or electron beam. However, the invention is applicable also to case where the charged-particle source is a source of longer particle, preferably electron, pulses, i.e. pulses of Full-Width-at-Half-Maximum, FWHM, duration > 100 picoseconds, preferably > 1 nanosecond. Preferably, the charged-particle source is an essentially or at least partially continuous charged-particle source, preferably an essentially or at least partially continuous electron source, for example a thermionic emitter made of tungsten or LaB6, or a field emitter such as a Schottky field emitter or cold field emitter, or a multi-cathode emitter array. The present invention prefers a continuous charged-particle source, however, also accepts sources able to provide long electron pulses, e.g. by electronically switching or gating a standard continuous charged-particle source. The present invention thus advantageously avoids the use of more complicated few-picosecond or sub-picosecond charged-particle, e.g. electron, sources which use femtosecond laser triggered photo cathodes.

In other words, the present invention avoids in particular the use and the need of femtosecond laser triggered photo cathodes which usually are limited in brightness and average current, in particular due to the limited pulse repetition rates achievable with femtosecond laser systems which are usually in the range of kHz or exceptionally in the range of MHz, however in particular in this case with relatively low laser pulse energy.

The apparatus further comprises a beam modulation member (see below) arranged on the main beam axis and a means for holding or providing an object to be examined, preferably a sample holder.

Objects to be examined can for example be nanophotonic elements or portions thereof such as metamaterials or waveguide structures. The apparatus can be designed to allow for various objects to be examined such as molecules, biomolecules, atoms, crystals, hard and soft materials, nanostructures, liquids, solutions, and biological specimen. For example, the means for holding or providing an object to be examined can be a sample holder when examining nanophotonic elements, crystals, hard or soft materials, nanostructures or the like. When examining molecules, the means for holding or providing an object to be examined can be realized by an appropriate gas nozzle for providing a gas jet into a vacuum chamber. When examining liquids or objects in solution/suspension, a liquid sample can similarly be held in an appropriate sample holder or provided into an examination chamber e.g. using a suitable nozzle or the like. Further suitable means for holding or providing an object to be examined will be apparent for the skilled person.

According to the invention, the apparatus further comprises a detector, preferably a two dimensional detector and/or a detector with energy/energy-loss resolution, for detecting charged-particles emanating from the object to be examined. The detector is adapted to detect charged particles that pass the object to be examined, that are scattered from the object to be examined, that are emitted by the object to be examined, or that reach the detector from the charged-particle source after any kind of interaction with the object to be examined.

According to an embodiment of the monitoring apparatus, the detector is adapted to detect an image of the object to be examined which is transferred e.g. onto a computer screen or the like. Suitable detectors are two dimensional detectors known in the art used for detecting beams of charged particles such as electron beams. For example, a CCD camera, CMOS camera, direct electron detector or other suitable detectors can be used.

The monitoring apparatus according to the invention can comprise a charged-particle optics by which the object to be examined is illuminated such that an image or diffraction pattern or other information of the object to be examined can be suitably projected onto the detector. Using such detector it becomes possible to detect deviations or deflections or momentum changes in the beam of charged particles caused for example by electromagnetic fields at the object to be examined by detecting corresponding deviations in the corresponding image of the object to be examined on the detector. For example, in the case of a nano-fabricated device being the object to be examined, electromagnetic fields can be created by exciting the device e.g. using optical or infrared laser light or terahertz radiation or pulses/pulse trains of charged particles, for example electrons.

According to the invention, the charged-particle monitoring apparatus further comprises a laser source which emits a laser beam which is guided (e.g. using standard laser mirrors or similar suitable laser guiding components) onto the beam modulation member so that the beam of charged particles intersects with the laser beam at the beam modulation member. Thereby an interaction (i.e. electromagnetic interaction) of the beam of charged particles and the laser beam occurs which results in a modulation, preferably a temporal or sideways modulation, of the beam of charged particles. The charged-particle monitoring apparatus can comprise an essentially continuous laser source adapted to emit an at least partially continuous laser beam.

According to the invention, the charged-particle source and the laser source of the apparatus can be arranged within the apparatus and if necessary, laser and charged-particle optics components are provided so that the laser beam and the charged-particle beam are overlapped at the beam modulation member. Thereby, both beams may be directed onto essentially the same portion or spot of the beam modulation member from the same side or the beams may be directed onto the beam modulation member from different sides, so that both beams are overlapped at least inside of the beam modulation member. The arrangement of these components within the apparatus is thus chosen such that the laser beam (i.e. its electromagnetic fields) interacts with the beam of charged particles. It is advantageous to choose the beam waist, i.e. the diameter (e.g. diameter at FWHM intensity), of the laser beam large enough so that the laser intensity and thus the electromagnetic peak field strength present within the region of overlap with the charge particle beam is essentially constant across the charged particle beam.

In case that the laser source is an essentially continuous laser source, the at least partially continuous laser beam of the same can be a continuous wave, cw, laser beam, potentially electronically switched or temporarily modulated, or a train of long and thus essentially continuous laser pulses, e.g. a train of laser pulses with a duration (e.g. FWHM duration) of at least 100 picoseconds, preferably of at least 1 nanosecond. The present invention thus prefers the use of continuous electron and laser sources. However, the invention also accepts the use of laser and charged particle sources which provide long laser and charged particle pulses. Even though the specific length is not essential, a long pulse in the sense of the invention is much longer than e.g. a femtosecond pulse. Generally, charged-particle and laser pulses acceptable are thus longer than e.g. about 100 picoseconds, preferably longer than about 1 nanosecond. In the case that both the laser source as well as the electron source is such long-pulse source, it is preferred that both sources are mutually synchronized in time.

In applications of the invention, the use of ultrashort laser pulse sources is avoided such as femtosecond laser pulse sources, which are undesirably complex systems usually having limited average power and repetition rate. As opposed to such temporarily short pulses of extremely high frequency bandwidth, the present laser source is either continuous or provides temporarily long pulses of low frequency bandwidth. In a preferred embodiment, the frequency bandwidth of the essentially continuous laser source is smaller than 10 GHz, preferably smaller than 1 GHz and most preferably smaller than 100 MHz. Preferably, the essentially continuous laser source is a continuous wave, cw, laser source, and the at least partially continuous laser beam is a continuous wave, cw, laser beam.

The overlap of the beam of charged particles and the laser beam at the beam modulation member results in an electromagnetic interaction of the two beams. In other words, the charged particles are subject to Lorentz forces in the laser field cycles. In free space, when e.g. an electron beam and the laser beam are overlapped without further elements, charged particles are periodically accelerated by the laser's electromagnetic fields, but the overall effect on momentum change cancels out due to the sinusoidal nature of the forces, so that after transmission through the laser beam, the particle beam momentum is unchanged. In order to achieve a net modulation effect, e.g. compression or deflection, the beam modulation member is provided to break the symmetry leading to canceling out of the effect. Depending on the laser phase, the electromagnetic laser fields in the overlap region before the beam modulation member cause periodic acceleration or deceleration or sideways deflection of the beam of charged particles, which add up until the charged particles enter the beam modulation member, at which point different forces continue to interact. Therefore, there remains after integration over the entire electron trajectory a phase-dependent acceleration or deceleration or deflection that is dependent on the laser phase at the time the particle passes the beam modulation member.

The beam modulation member preferably comprises a foil or similarly shaped element. Preferably, such foil (or sheet, film or also membrane) is provided with a thickness (at least at the position of passage of the charged-particle beam) so that charged particles can pass through without a significant decrease in beam brightness. The beam modulation member can for example be formed by a frame structure holding a foil at the position of charged-particle passage. Different ways to provide a thin, foil like structure at the position of charged-particle beam passage may similarly possible. In a preferred embodiment, the thickness of the foil (preferably at the position of passage of the beam of charged particles) is chosen such that the transmission of charged particles is more than 50%, preferably more than 80%, more preferably more than 90% relative to the beam current incident on the foil.

According to the invention a very thin free-standing foil with thicknesses down to about 1 nm, e.g. using the material Graphene, can be used. However, charged particle beams according to the invention can also penetrate through thicker materials, depending on their energy and mass. Preferably, the foil has a minimum thickness of 1 nm to 500 nm, preferably 5 nm to 250 nm, more preferably of 5 nm to 125 nm and most preferably of 5 nm to 80 nm. As it will be clear to the skilled person, such foil thickness may vary across the area of the foil with the usual tolerances or shapes given by the foil fabrication. The foil can have holes, can be curved or shaped. The beam modulation member can be of different form, e.g. formed by parallel nanowires, or can be an appropriately shaped longitudinal nanostructure in which the laser field and the particles travel in part in parallel. In order to achieve this effect, the beam modulation member can be adapted to break and particularly has a shape which is designed to break the symmetry of the normally periodic electromagnetic particle-field interaction so that the forces do not average out after the interaction. However, providing the beam modulation member in form of a foil is of particular advantage in terms of simplicity and practicability.

By appropriately controlling the laser polarization with respect to the direction of the charged particle beam, the direction of the laser's electromagnetic force can be adjusted to be either essentially parallel to the beam direction or essentially perpendicular to said direction. To this end, the laser polarization is controlled by e.g. optical or electrooptical elements to be preferably elliptical, more preferably linear, in order to produce efficient modulation.

Choosing the laser polarization such that the laser's electromagnetic forces have a direction parallel to the charged particle motion, these forces cause a modulation of the beam in time with a period that is determined by the optical frequency. At every valley of the time-integrated force there is compression, i.e. particles in front are slightly slowed down and such behind are slightly accelerated. The originally continuous particle beam is thus modulated as depending on time, some charged particles are accelerated and some are decelerated. This periodic acceleration and deceleration along the electron beam causes after a given propagation distance a periodic compression of the beam, which reshapes into a train of short electron pulses. This point of maximum compression is referred to herein as temporal focus. After this point, the pulses become longer and the pulse train disperses. In other words, the charged particle beam becomes modulated by the laser field cycles so that its density strongly varies along the beam direction. The periodic compression results in a sequence of beam portions with peak density followed by beam portions with very low density. We refer to such density modulated beam as train of pulses, each pulse being a portion of high density followed by a low density portion. Thus, due to the sub-optical-wave-cycle interaction between the laser beam and the particle beam and the beam modulation member, a train of few-femtosecond or attosecond particle pulses can be achieved at the position of maximum compression (temporal focus). Thus, in a preferred embodiment, the interaction of the beam of charged particles and the laser beam converts the beam of charged particles into a train of pulses of charged particles. In other words, in a preferred embodiment, the interaction of the beam of charged particles and the laser beam results in a compression of the charged particles into pulses at a spatial position (temporal focus) along the main beam axis different from the position of interaction between the laser beam and the beam of charged particles.

Due to usual tolerances and imperfections, the charged particle density will most likely not fall to perfectly zero between the pulses, but that very similar to the case of laser pulses, some residual charged particles may be present also in between the pulses. Thus such typical background (non-zero density portion between the pulses) may include typically about 30% of the charged-particles, while typically about 70% of the charged-particles may be expected to concentrate in the peaks. These numbers are only examples whereby the actual distribution of particles into pulses and background will be determined by the particles' energy bandwidth and divergence, by the shape and intensity of the laser field cycles, by the shape and material of the beam modulation member and by other constructional circumstances of the apparatus.

Choosing the laser polarization so that the laser's electromagnetic forces have a direction perpendicular to the charged particles motion, these forces cause a time-dependent sideways deflection. The magnitude of the time-integrated force depends on the phase of the laser light at the position of interaction with the charged-particle beam and its direction is within the plane of laser polarization. This phase-dependent sideways deflection can be used to filter out (using a spatial filter such as e.g. a simple aperture or a simple beam block) a few-femtosecond or attosecond particle pulse train with a pulse separation determined by the optical cycle time.

An advantage of the compression mode is preservation of the spatial beam parameters and production of shorter final pulses, which can at the temporal focus become shorter than the laser's half-cycle time due to the modulation in time. On the other hand, the deflection mode with a spatial filter can also produce a sub-optical-cycle pulse train and might have specific uses, for example in combination with the compression for removing background particles.

Thus, preferably, the interaction of the beam of charged particles and the laser beam results in a periodic acceleration, preferably acceleration and deceleration, of the charged particles at the position of interaction between the laser beam and the beam of charged particles. By controlling the laser polarization in the vicinity of the beam modulation member to have components in the direction of the charged particles, the charged particles are accelerated/decelerated thus yielding a periodic compression of the charged particle beam, i.e. a train of charged particle pulses. Thus, in a preferred embodiment, the interaction of the beam of charged particles and the laser beam results in a compression of the charged particles at a temporal focus (see above).

Alternatively, by adjusting the effective laser polarization to have an electromagnetic force component perpendicular to the axis of the charged particle beam, the interaction produces a periodic and phase-dependent sideways deflection. Thus, in a preferred embodiment, the interaction of the beam of charged particles and the laser beam results in a sideways deflection of at least a fraction of the charged particles away from the main beam axis. Particles within the beam of charged-particles being exposed to a given laser phase are sideways deflected out of the main beam. Thus, there is a relation between the sideways momentum change and the laser phase. Due to for example particle beam divergence, imperfect overlap between laser and charged-particle beam or imperfections of the beam modulation member, this relation might not be perfect. For each laser phase, the fraction of particles obtaining the corresponding sideways momentum change may in an extreme case be < 50%, but preferably < 20 % and more preferably < 10%, while the corresponding other fraction is not deflected or deflected elsewhere. The desirably deflected fraction of particles propagates in the absence of any further laser fields along a new beam axis which is at an angle to the main beam axis. Again, such beam axis can be curved depending on any electromagnetic or gravitational fields present along such axis. A correspondingly designed spatial filter at a position further along the particle main axis, for example an aperture, selects the desirably deflected charged particles from the other ones. Thus, after the spatial filter, a beam of charged particles is formed which consists of pulses with a duration given by a fraction the laser cycle time, for example few-femtoseconds or attoseconds. The narrower and farther the spatial filter is placed, the shorter the pulses will be, at cost of a decrease in current.

In accordance with the present invention as described above, it becomes possible to achieve extremely short pulse durations at the position of the temporal focus or another point further along the particle propagation direction. Thus, in a preferred embodiment the compression or deflection of the charged particles results in pulses of charged particles having a Full-Width-at-Half-Maximum, FWHM, duration which is shorter than 30 fs, preferably shorter than 10 fs, more preferably shorter than 5 fs, and most preferably shorter than 1 fs at a spatial position along the main beam axis different from the position of interaction between the laser beam and the beam of charged particles, i.e. at the temporal focus.

In a preferred embodiment, the interaction of the beam of charged particles and the laser beam is adapted to compress the charged particles at the temporal focus. In a further preferred embodiment, the means for holding or providing the object to be examined is provided at the position of said temporal focus. In other words, at approximately the distance at which the charged particle beam has reshaped in time or has been filtered preferably into a sub-optical-cycle-duration pulse train, there is the object to be examined.

Even though it is possible that the beam modulation member is formed from or comprises a metal, it turned out that using dielectric or semiconductor materials is of advantage. Thus, in a preferred embodiment, the beam modulation member comprises or is made of a dielectric or semiconductor material as described below.

According to the invention, the material of the beam modulation member thus comprises a dielectric or semiconductor material. Dielectric materials, for example sapphire, silicon dioxide, fused silica, silicon nitride, aluminum nitride, diamond, salt crystals, plastics or glass are highly transparent at optical frequencies and therefore sustain large laser power. Given this exemplary list, the skilled person will recognize further dielectric materials that are not mentioned but that are similarly applicable in connection with the present invention. Doped or undoped semiconductors, for example silicon, germanium, graphite, graphene, gallium arsenide, gallium nitride, zinc selenide, titanium dioxide, silicon carbide, aluminum nitride, or similar single-component or multi-component semiconducting materials are in addition partially conductive, which can help for example in reducing charging effects of the particle beam. Given this list of semiconductor materials, the skilled person will recognize further semiconductor materials that are suitable to be used in the context of the present invention even though they are not explicitly mentioned. Mixtures of dielectric and semiconductor materials are similarly suitable.

Preferably, the material of the beam modulation member has a dielectric constant between 1 and 10, preferably between 1.05 and 5, and a thickness chosen as described above, such that the beam modulation member generates an optical phase shift after transmission and/or a reduced force during the time of particle transmission through the foil by a reduction of the optical electric field inside, in order to break the symmetry of particle acceleration in the laser cycles.

Dielectric or semiconductor materials are of particular advantage, because they have a high damage threshold to laser light. Therefore it becomes possible to use e.g. a high power cw laser to achieve the necessary field strength for beam modulation into a sub-optical-cycle pulse train in a continuous, non-pulsed manner without destroying the beam modulation member and without having time ranges during which no modulation occurs.

This results in a considerable increase in achievable brightness and average current of the charged-particle beam, as a continuous charged particle beam can be modulated with a continuous laser beam, to be continuously modulated. By avoiding a femtosecond laser for electron generation and/or modulation, a pulsed electron source with limited brightness and limited current can be avoided. It becomes thus possible to produce a flux of pulsed charged particles at the sample at almost the same average current as available from the source. This current is a factor of 1000 more than available in ultrafast electron microscopy. At the same time sub-optical-cycle electron pulse duration can be achieved, which is a factor of 100-1000 shorter than in ultrafast electron microscopy.

In this respect, it is preferable to use a material from the above mentioned list of materials which is highly transparent to laser light, as such material is less susceptible to damage caused by absorption. Thus, preferably less than 10%, more preferably less than 1%, even more preferably less than 0.1% and most preferably less than 0.01% of laser power is absorbed by the beam modulation member.

When choosing appropriate materials from the dielectric and semiconductor family, for example from the above mentioned list of materials, it is advantageous to select materials of low sheet resistance, preferably lower than 1020 Ω/sq, in order to avoid charging-up of the beam modulation member by the charged particle beam. By connecting the beam modulation member which is selected to have a sufficiently low sheet resistance to ground, it becomes possible to avoid such charging up.

There are some special angle combinations between the foil orientation, the laser incidence and the polarization vector that make the concept particularly effective. For compression, the laser's polarization state in the vicinity of the foil must project the optical electric field in part onto the propagation direction of the charged particles, in order to provide the time-dependent longitudinal electric field components that are the cause for compression. For deflection, the laser's polarization state in the vicinity of the foil must project the optical electric field in part perpendicularly to the particle beam, in order to provide effective sideways forces without cancelation by magnetic deflection effects. Therefore not directly the laser's incident polarization but the effective polarization close to and within the beam modulation member needs to be adjusted for the desired effect. In the example case that the charged particle beam, the laser beam and the normal of the beam modulation member, preferably a foil, are all in the same plane, the incident laser preferably has p-polarized components with respect to the beam modulation member. For an s-polarized incidence, there is almost no final modulation effect, because the electric and magnetic forces largely cancel out each other's net effect.

When the laser beam and the charged particle beam intersect at the beam modulation member, the laser beam waist is preferably larger than the electron beam diameter. Preferably, the laser beam diameter (FWHM) is larger than the corresponding charged-particle beam diameter by a factor of at least two, better between 2 and 10, and preferably as high as allowable by the available laser power. In this way, a homogeneous compression or deflection strength and an approximately equal temporal focus distance for all charged particles in a beam profile can be achieved.

In order to fulfill "velocity matching", meaning that each part in an electron beam of finite diameter acquires the same compression or deflection effect over the beam profile, the angle of the beam modulation member is preferably chosen such that the arrival time of the electrons (moving a fraction of the speed of light) and the arrival time of the laser field cycles (moving at speed of light) are made equal on every location on the beam modulation member, by a proper choice of geometry. Thus, in a preferred embodiment, the beam modulation member is essentially a foil or comprises a foil which is arranged on the main beam axis at an angle with respect to the beam of charged particles and the laser beam such that the projected surface incidence velocity of the charged particles and of the laser are made essentially equal. For example electrons at 70 keV energy have a velocity of about 0.48 times the speed of light. The surface velocity at an angle of 20° is about 1.4 times the speed of light. If the laser beam propagating at the speed of light is incident at about 45° or 225°, it also has a surface velocity of 1.4 times the speed of light. Effectively, each part of the electron beam therefore experiences the same time delay with respect to the laser's field cycles. Other suitable angle combinations at other particle energies are simple to calculate for an expert in the field.

Particular efficiency in compression can be achieved when the laser beam and the charged particle beam are incident from different sides of the foil. Because the main effect originates from a phase shift between the optical wave cycles at the two sides, this effect can be maximized if the charged particle propagates in opposite direction to the wave propagation, in which case the transit time through the foil increases instead of reduces the effective phase delay at injection into the field cycles at the other side. Thus, in a preferred embodiment, the laser beam and the beam of charged particles are incident onto the beam modulation member from different sides.

Preferably, the laser intersects the charged-particle beam at close to 90°. It becomes thus possible that in an actual setup, e.g. when applied in an electron microscope, the laser can enter and leave the electron beam path through vacuum windows at the side of an electron microscope column. In this way, presence of the outgoing laser beam in the microscope or the need for a beam stop or mirror inside can be avoided. Thus, the presence of undesirable laser stray light caused by the laser used for electron beam modulation on the detector can be avoided. Therefore, in a preferred embodiment, an angle formed by the main beam axis and an axis of laser beam propagation is in between 20° and 160°, preferably in between 45° and 135°, more preferably in between 60° and 120° and most preferably in between 80° and 100°.

Preferably, only a first part of the laser light is used for modulating the particle beam. A second part of the laser is split and is used either directly or converted into its harmonics or other frequencies to excite electromagnetic or optical phenomena at the object to be examined. Alternatively, the second part split from the laser can be replaced by a different laser which is synchronized, i.e. phase-locked, with the first part of the laser light. Electromagnetic fields thus created in the sample locally deflect the particle pulse train or change its momentum, which becomes visible at the detector as a correspondingly deflected or energy-changed signal. The visible effect depends on the phase or time delay between the two laser waves, i.e. between the wave causing the electromagnetic fields at the object to be examined and the wave modulating the particle beam. Thus, by detecting the particle beam or secondary particles emanating from the sample in dependence of the phase shift between these two waves, a pump-probe monitoring of the electromagnetic fields at the sample becomes possible with sub-optical-cycle time resolution.

Thus, in a preferred embodiment, the charged-particle monitoring apparatus further comprises optical elements to split the laser and guide a first laser beam onto the beam modulation member and a second laser beam onto an object to be examined held by the holding means, whereby the optical elements comprise means to shift the optical phase of the second laser beam at the position of the object to be examined with respect to the optical phase of the first laser beam at the beam modulation member.

Thereby, the means to shift the optical phase can be realized using for example an opto-mechanical delay, a material of varying optical path length, an electro-optical or magnetooptical modulator, a moving piece of material, a Pockels cell or an adjustable electronic phase lock of the laser. Further means suitable to produce a phase shift or delay between two laser beams will be apparent to the skilled person.

In a preferred embodiment, the laser is a single-longitudinal-mode laser. Using such laser, it becomes possible that the first laser beam and the second laser beam or the frequencies it generates or is locked to remain coherent even in case of different optical path lengths. It also avoids compression or deflection artifacts that could arise from a wave with fluctuating shape at the beam modulation member.

In order to appropriately image the object to be examined at the detector and visualize e.g. deflections or energy-modulations of the particle beam by fields created thereon, the charged-particle monitoring apparatus preferably comprises suitable charged-particle optics such as charged particle lenses, twin lenses, deflection elements, stigmators or octopoles. Even though it is in principle possible that the beam modulation member is located before or after the electron optics, placing the beam modulation member before, i.e. upstream, of some of the electron optics is advantageous for minimizing the necessary laser power while simultaneously maintaining the apparatus' spatial resolution. Potential temporal distortions of the particle optics can be minimized by collinear alignment and/or by reduction of the particle beam diameter. Thus, in a preferred embodiment, the charged-particle monitoring apparatus further comprises charged-particle optics for adjusting the beam of charged particles, wherein the charged-particle optics are arranged along the particle propagation axis after the beam modulation member.

In principle, the present invention is applicable to negatively and positively charged particles such as electrons, positrons, ions, protons or alpha-particles. However, the present invention is of particular advantage for the case of electrons as because of its simplicity it can be easily incorporated into an existing electron microscope which then results in a still relatively compact apparatus offering potentially sub-femtosecond time resolution at Angstrom spatial resolution. Therefore, in a preferred embodiment, the charged particles are electrons and the charged particle source is an electron source, for example a thermionic emitter made of tungsten or LaB6, or a field emitter, Schottky field emitter or cold field emitter, or a multi-cathode emitter array, at preferably an energy spread of < 2 eV or better < 0.7 eV, because a low spread avoids dispersion of the compressed electron pulses towards the temporal focus. In a preferred embodiment, the charged-particle monitoring apparatus is an electron microscope or is comprised by an electron microscope.

In accordance with all of the above features and aspects, the present invention further provides a method for time-resolved monitoring of ultrafast processes. The method comprises emitting a beam of charged particles along a main beam axis from a charged-particle source; directing the beam of charged particles onto a beam modulation member arranged on the main beam axis; directing the beam of charged particles onto an object to be examined and detecting charged-particles emanating from the object to be examined. The method further comprises modulating, preferably temporally modulating, the beam of charged particles by guiding an at least partially continuous laser beam onto the beam modulation member so that the beam of charged particles intersects with the laser beam at the beam modulation member.

In summary, even though the best devices currently available in terms of spatial and temporal resolution are based on femtosecond laser systems, the present invention discloses achieving further enhanced temporal resolution while maintaining the spatial resolution by deviating from the use of a pulsed laser system. By the provision of the subject-matter of claim 1, it becomes advantageously possible to transform for example a standard continuous-beam electron microscope into a device with sub-optical-cycle (e.g. attosecond) resolution, i.e. about a thousand times better than before. The present invention thus allows measurement of electromagnetic field vectors (and other dynamics) within and around matter with sub-optical-cycle time resolution. The invention neither requires a femtosecond laser, nor a photocathode electron source, nor an imaging energy filter, and can nevertheless fully maintain the average beam current and low emittance of state-of-the-art continuous electron sources (for example field emitters). When for example modifying an existing electron microscope, necessary modifications are simple and inexpensive. Thus, in a preferred embodiment, an electron microscope is provided comprising a charged-particle monitoring apparatus as described above. Alternatively, in a preferred embodiment, the charged-particle monitoring apparatus is an electron microscope.

According to the invention, a method is provided for time-resolved monitoring of ultrafast processes comprising emitting an at least partially continuous beam of charged particles along a main beam axis from a charged-particle source, directing the beam of charged particles onto a beam modulation member arranged on the main beam axis directing the beam of charged particles onto an object to be examined, detecting charged-particles emanating from the object to be examined. According to the invention, the method further comprises modulating the beam of charged particles by guiding an at least partially continuous laser beam onto the beam modulation member so that the beam of charged particles intersects with the laser beam at the beam modulation member.

The inventive method can be combined with all of the preferred embodiments of the present invention as they have been described above in connection with the charged-particle apparatus.

According to the invention, a charged-particle monitoring apparatus for time-resolved monitoring of ultrafast processes is provided, the monitoring apparatus comprising:
a charged-particle source, adapted to emit a beam of charged particles along a main beam axis;
a beam modulation member which is arranged on the main beam axis;
a means for holding or providing an object to be examined which is arranged on the main beam axis;
a detector for detecting charged-particles which emanates from the object to be examined and which is arranged on the main beam axis;
a laser source adapted to emit a laser beam so that the beam of charged particles intersects with the laser beam and an interaction of the beam of charged particles and the laser beam results in a modulation of the beam of charged particles,
wherein the beam modulation member comprises a dielectric or semiconductor material.

According to an embodiment of the charged-particle monitoring apparatus the beam modulation member is positioned such that the intersection point of the beam of charged particles lies in the cross-section of the beam modulation member.

According to an embodiment of the charged-particle monitoring apparatus the beam modulation member is adapted to absorb less than 10 %, more preferably less than 1 %, even more preferably less than 0.1 %, and most preferably less than 0.01 % of laser intensity.

According to an embodiment of the charged-particle monitoring apparatus the beam modulation member is formed as a foil which comprises a dielectric or a semiconductor material.

According to an embodiment of the charged-particle monitoring apparatus the beam modulation member comprises a holding device which holds the plate or foil.

According to an embodiment of the charged-particle monitoring apparatus the foil has a shape that the symmetry of the normally periodic electromagnetic particle-field interaction is broken.

According to an embodiment of the charged-particle monitoring apparatus the foil comprises at least one hole.

According to an embodiment of the charged-particle monitoring apparatus the foil comprises a plurality of holes which are distributed over the extension of the foil in a regular or irregular manner.

According to an embodiment of the charged-particle monitoring apparatus the foil is held by the holding device in a planar or curved shape.

According to an embodiment of the charged-particle monitoring apparatus the foil is held by the holding device in a curved shape.

According to an embodiment of the charged-particle monitoring apparatus the foil is stretched by the holding device while held in its shape by the holding device

According to an embodiment of the charged-particle monitoring apparatus the foil is held by the holding device in a stretched manner.

According to an embodiment of the charged-particle monitoring apparatus the foil has a minimum thickness of 1 nm to 500 nm, preferably 5 nm to 250 nm, more preferably of 5 nm to 125 nm and most preferably of 5 nm to 80 nm.

According to an embodiment of the charged-particle monitoring apparatus the foil of the beam modulation member is arranged on the main beam axis at an angle with respect to the beam of charged particles and the laser beam such that the projected surface incidence velocity of the charged particles and of the laser are made equal.

According to an embodiment of the charged-particle monitoring apparatus the laser beam and the beam of charged particles are incident onto the beam modulation member from opposed sides of the beam modulation member or the foil.

According to an embodiment of the charged-particle monitoring apparatus the interaction of the beam of charged particles and the laser beam results in a periodic acceleration of the charged particles at the position of interaction between the laser beam and the beam of charged particles.

According to an embodiment of the charged-particle monitoring apparatus the interaction of the beam of charged particles and the laser beam results in a compression of the charged particles into pulses at a spatial position along the main beam axis different from the position of interaction between the laser beam and the beam of charged particles.

According to an embodiment of the charged-particle monitoring apparatus the electromagnetic interaction of the beam of charged particles and the laser beam results in a sideways deflection of at least a fraction of the charged particles away from the main beam axis.

According to an embodiment of the charged-particle monitoring apparatus a frequency bandwidth of the essentially continuous laser source is smaller than 10 GHz, preferably smaller than 1 GHz and most preferably smaller than 100 MHz.

According to an embodiment of the charged-particle monitoring apparatus the compression or deflection of the charged particles results in pulses of charged particles having a Full-Width-at-Half-Maximum, FWHM, duration which is shorter than 30 fs, preferably shorter than 10 fs, more preferably shorter than 5 fs, and most preferably shorter than 1 fs at a spatial position along the main beam axis different from the position of interaction between the laser beam and the beam of charged particles.

According to an embodiment of the charged-particle monitoring apparatus the charged-particle source is an essentially continuous electron source or emits electron pulses with a Full-Width-at-Half-Maximum, FWHM, duration which is longer than 100 picoseconds, preferably longer than 1 nanosecond.

According to an embodiment of the charged-particle monitoring apparatus, the monitoring apparatus further comprising optical elements to split the laser beam, or means to produce a phase-locked second laser beam, and guide a first laser beam onto the beam modulation member and a second laser beam onto an object to be examined and held by holding means, whereby the optical elements comprise optical phase shifting means adapted to shift the optical phase of the second laser beam at the position of the object to be examined with respect to the optical phase of the first laser beam at the beam modulation member.

According to an embodiment of the charged-particle monitoring apparatus the laser is a single-longitudinal-mode laser.

According to an embodiment of the charged-particle monitoring apparatus the charged-particle monitoring apparatus further comprises a charged-particle optics for adjusting the beam of charged particles, wherein the charged-particle optics are arranged along the main beam axis after the beam modulation member.

According to an embodiment of the charged-particle monitoring apparatus the charged particles are electrons.

According to a further aspect of the invention, an electron microscope is provided which comprises a charged-particle monitoring apparatus according to any one of the herein described embodiments of the same. In this regard, the monitoring apparatus is physically and functionally integrated in the electron microscope.

According to a further aspect of the invention, a method for time-resolved monitoring of ultrafast processes is provided, the method comprising:
emitting a beam of charged particles along a main beam axis from a charged-particle source,
directing the beam of charged particles onto a beam modulation member arranged on the main beam axis, wherein the beam modulation member comprises a dielectric or semiconductor material;
directing the beam of charged particles onto an object to be examined;
detecting charged-particles emanating from the object to be examined;
modulating the beam of charged particles by guiding a laser beam onto the beam modulation member so that the beam of charged particles intersects with the laser beam and thereby interacting of the beam of charged particles and of the laser beam and modulation of the beam of charged particles.

In the following, the invention is described exemplarily with reference to the enclosed figures in which:
Fig. 1 shows a schematic illustration of a charged-particle monitoring apparatus;
Fig. 2 shows results of a numerical simulation illustrating for a set of example parameters the achievable electron pulse compression.

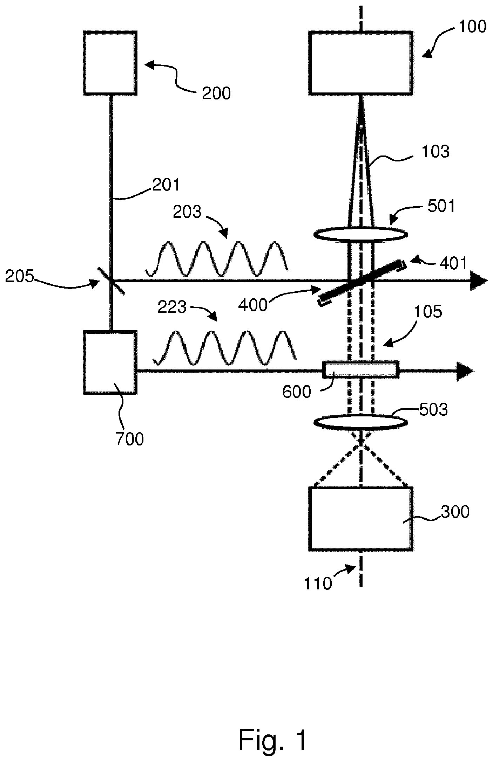

Figure 1 exemplarily illustrates a charged-particle monitoring apparatus. The used dimensions and angles are only schematic. The apparatus uses an electron source 100 to generate an electron beam 103 which is incident onto a beam modulation member. In the shown example the beam modulation member is realized by foil 400 or plate. Electron optics realized by suitable electromagnetic lenses 501, 503 are used to form the illuminating beam and to magnify an image onto a detector 300, which is for example a two-dimensional camera or an electron counting device and/or an energy filter, and measures intensity changes from sideways beam deflections or changes of electron energy due to the electromagnetic fields at the sample. The beam modulation member 400 can comprise a holding device 401 which holds the plate or foil of the modulation member 400.

A laser source 200, for example a 50 W single-longitudinal-mode laser at 1.9 µm wavelength is focused to approximately 50 µm beam diameter at the foil to interact with the electron beam. In the present example, the resulting electrical fields of about 3x106 V/m cause a temporal modulation of the electron beam, i.e. the electron beam is reshaped by means of a laser wave 203 into a regular sequence of electron pulses having sub-optical-cycle duration. The resulting electron pulse train is illustrated in Fig. 1 using dashed lines 105.

As shown, a suitable beam splitter 205 is used to split the laser beam 201 into a first laser beam 201 and a second laser beam 223. As explained above, as an alternative to the splitting 205, a separate laser that is phase locked to the first laser beam 201 can also be used. The first laser beam 201 is used for the above described modulation of the electron beam 103 and the second laser beam 223 is subjected to phase shifting with respect to the first laser beam using optical phase shifting means 700 to shift the optical phase, for example with an opto-mechanical delay or an electro-optical modulator. The so phase shifted second laser beam 223 is guided to an object 600 to be examined, for example a nanophotonic structure or waveguide, into overlap with the train of electron pulses 105. The second laser beam causes electromagnetic fields at the object to be examined. These fields result in local deflection or momentum changes of the electron beam, which in turn become visible as corresponding deviations on the detector 300. These deviations depend on the relative phase shift between the first and the second laser beam so that it becomes possible to track at sub-optical-cycle resolution the temporal evolution of the electromagnetic fields in the object 600 by taking detector images 300 for different phase shifts achieved using the optical phase shifting means 700 in a pump-probe manner.

One of the advantages provided by the present invention is that by using the beam modulation member 400 comprising a dielectric or semiconductor material (or a suitable mixture thereof) and designed in the way disclosed above, the necessity of using a femtosecond laser can be avoided. In this way the high average current and brilliance of an essentially continuous source 100 can therefore be maintained and at the same time a temporal resolution of sub-optical-cycle can be achieved.

The present inventor carried out experiments and tested a 60 nm thick Silicon foil (Norcada, Inc.) and a 50 nm thick SiN foil (Plano GmbH) with a 50-W continuous-wave laser at 1.9 µm wavelength (a Thulium fiber laser, IPG Photonics GmbH), which was focused to 50 µm beam diameter. These conditions provide sufficient field strength for sub-optical-cycle pulse train formation. Although the average power is 1000 times higher than achievable with femtosecond lasers, the foils did not show any kind of damage even after many minutes of illumination.

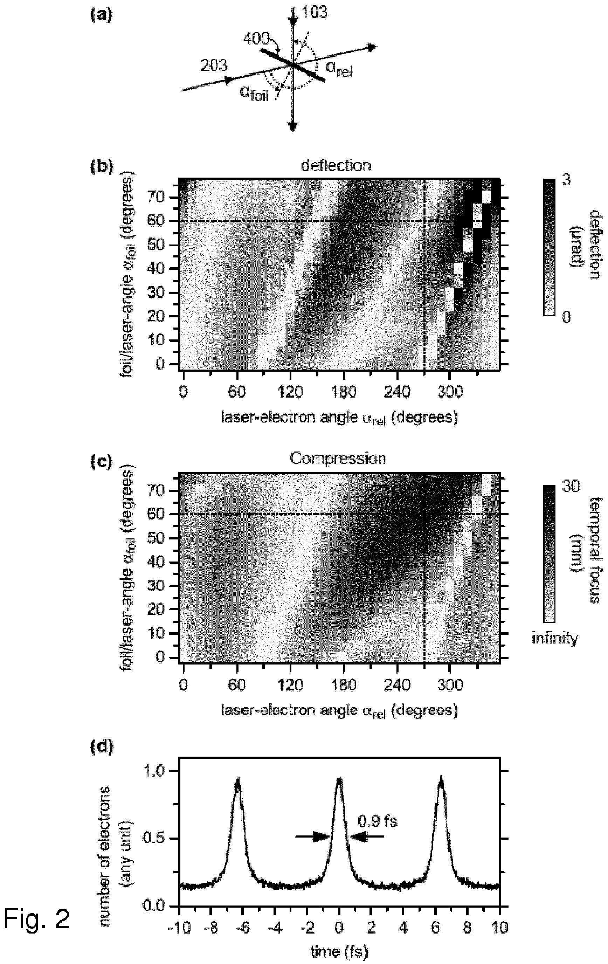

Fig. 2 shows the results of a numerical simulation on momentum exchange at the above mentioned example conditions. Part (a) of Fig. 2 shows the investigated example geometry that is intended for compression of an electron beam 103 with a continuous laser 203 at a semiconductor foil 400 (60 nm silicon). Part (b) and (c) show the results. The example case assumes electrons with 70 keV energy and 0.3 eV bandwidth. They pass through a 60-nm silicon foil and overlap with an essentially continuous laser beam of 50 W power and 50 µm beam diameter. As discussed above, the experiments showed that at these parameters there is no damage caused to the foil.

Part (b) of Fig. 2 shows the peak sideways deflection in dependence of the two angles depicted in part (a).

Part (c) shows the location of the temporal focus in dependence of the two angles.

It can be taken from Fig. 2 that there is a complex interplay between the two angles on the peak momentum exchange. For example, sideways deflection can cancel out for certain angle combinations, notably if the electrons hit the foil approximately with perpendicular incidence (αrel - αfoil ≈ 90°). In contrast, the longitudinal momentum exchange effect (causing compression in time) shows a different dependence on the angles as compared the deflection. A temporal focus, i.e. location where the sub-optical-cycle pulse train appears, can be realized that is closer than 30 mm for the laser parameters explained above. In other words, a minimum compressed pulse duration is achieved 30 mm after the beam modulation member, e.g. after the foil.

The calculations further show that with a tighter focus of the laser and/or foils of optimized thickness and material, a tenfold closer location of the temporal focus can realistically be achieved, if this is necessary in the application. The dotted lines in Figure 2 parts (b) and (c) denote the optimum conditions for the considered example foil, maximizing the compression effect while minimizing sideways deflection. The laser-electron angle is about 90°, which is very convenient to realize in an electron microscope, because the electron beam can go in and out at the sides of a microscope column (main axis). Silicon's electrical conductivity at room temperature and moderate doping is 101-103 Ω cm. Accordingly, an electron beam current of 1 nA produces at a 102 Ω cm, 60 nm, 1 mm2 foil that is grounded at the edges a charging of only about 10 mV at the center, which is insignificant.

Part (d) of Fig. 2 depicts the simulated temporal shape of the electron beam at the temporal focus. It has converted into a train of attosecond electron pulses that have a temporal separation that is synchronized to the laser cycles. Synchronous sample excitation and probing is therefore possible without large effort. More than 70% of the electrons are concentrated in the peaks and only about 30% in the background. This latter part can in dependence on the details of the measurement produce a non-time-dependent background signal, but this can be subtracted from the time-dependent pump-probe results by a reference measurement without compression and by subsequent normalization.

In summary, compression of a continuous electron beam with the help of a dielectric or semiconductor foil and an essentially continuous-wave laser is a viable and feasible approach for adding sub-optical cycle (attosecond) resolution to a standard electron microscope, in order to enable for the first time a direct spatiotemporal investigation of, for example, the electromagnetic phenomena in nanophotonic circuitry or metamaterials.

## Claims

1. Charged-particle monitoring apparatus for time-resolved monitoring of ultrafast processes, the monitoring apparatus comprising:
a charged-particle source (100), adapted to emit a beam of charged particles (103) along a main beam axis (110);
a beam modulation member (400) which is arranged on the main beam axis (110);
a means for holding or providing an object (600) to be examined which is arranged on the main beam axis (110);
a detector (300) for detecting charged-particles (105) which emanates from the object (600) to be examined and which is arranged on the main beam axis (110);
a laser source (200) adapted to emit a laser beam (201) so that the beam of charged particles intersects with the laser beam (201) and an interaction of the beam of charged particles (103) and the laser beam (203) results in a modulation of the beam of charged particles,
wherein the beam modulation member (400) comprises a dielectric or semiconductor material,
wherein the beam modulation member (400) is positioned such that the intersection point of the beam of charged particles lies in the cross-section of the beam modulation member (400).

2. Charged-particle monitoring apparatus according to claim 1, wherein the beam modulation member is adapted to absorb less than 10%, more preferably less than 1%, even more preferably less than 0.1%, and most preferably less than 0.01% of laser intensity.

3. Charged-particle monitoring apparatus according to any one of the preceding claims, wherein the beam modulation member (400) is formed as a foil which comprises a dielectric or a semiconductor material.

4. Charged-particle monitoring apparatus according to one of the preceding claims, wherein the beam modulation member (400) comprises a holding device which holds the plate or foil.

5. Charged-particle monitoring apparatus according to claim 3 or 4, wherein the foil comprises at least one hole.

6. Charged-particle monitoring apparatus according to one of the preceding claims, wherein the foil is stretched by the holding device while held in its shape by the holding device or wherein the foil is held by the holding device in a stretched manner.

7. Charged-particle monitoring apparatus according to one of claims 4 to 12, wherein the foil has a minimum thickness of 1 nm to 500 nm, preferably 5 nm to 250 nm, more preferably of 5 nm to 125 nm and most preferably of 5 nm to 80 nm.

8. Charged-particle monitoring apparatus according to any one of the preceding claims, wherein the laser beam (203) and the beam of charged particles (103) are incident onto the beam modulation member (400) from opposed sides of the beam modulation member (400) or the foil.

9. Charged-particle monitoring apparatus according to any one of the preceding claims, wherein the interaction of the beam of charged particles (103) and the laser beam (203) results in a periodic acceleration of the charged particles at the position of interaction between the laser beam and the beam of charged particles.

10. Charged-particle monitoring apparatus according to any one of the preceding claims, wherein the electromagnetic interaction of the beam of charged particles (103) and the laser beam (203) results in a sideways deflection of at least a fraction of the charged particles away from the main beam axis (110).

11. Charged-particle monitoring apparatus according to any one of the preceding claims, wherein a frequency bandwidth of the essentially continuous laser source (200) is smaller than 10 GHz.

12. Charged-particle monitoring apparatus according to any one of the preceding claims, the monitoring apparatus further comprising optical elements (205) to split the laser beam (201), or means to produce a phase-locked second laser beam, and guide a first laser beam (203) onto the beam modulation member (400) and a second laser beam (223) onto an object (600) to be examined and held by holding means, whereby the optical elements comprise optical phase shifting means (700) adapted to shift the optical phase of the second laser beam (223) at the position of the object to be examined with respect to the optical phase of the first laser beam (203) at the beam modulation member.

13. Charged-particle monitoring apparatus according to any one of the preceding claims, wherein the laser is a single-longitudinal-mode laser.

14. Electron microscope **characterized in that** it comprises a charged-particle monitoring apparatus according to any one of the preceding claims.

15. Method for time-resolved monitoring of ultrafast processes, the method comprising:
emitting a beam of charged particles (103) along a main beam axis (110) from a charged-particle source (100),
directing the beam of charged particles (103) onto a beam modulation member (400) arranged on the main beam axis (110), wherein the beam modulation member (400) comprises a dielectric or semiconductor material;
directing the beam of charged particles (103) onto an object (600) to be examined;
detecting charged-particles (103) emanating from the object (600) to be examined;
modulating the beam of charged particles (103) by guiding a laser beam (203) onto the beam modulation member (400) so that the beam of charged particles intersects with the laser beam and thereby interacting of the beam of charged particles (103) and the laser beam (203) and modulating the beam of charged particles.

## Patentansprüche

1. Überwachungsgerät für geladene Teilchen zur zeitaufgelösten Überwachung von ultraschnellen Prozessen, wobei die Überwachungsvorrichtung umfasst:
eine Quelle (100) für geladene Teilchen, die geeignet ist, einen Strahl geladener Teilchen (103) entlang einer Hauptstrahlachse (110) zu emittieren;
ein Strahlmodulationselement (400), das auf der Hauptstrahlachse (110) angeordnet ist;
ein Mittel zum Halten oder Bereitstellen eines zu untersuchenden Objekts (600), das auf der Hauptstrahlachse (110) angeordnet ist;
einen auf der Hauptstrahlachse (110) angeordneten Detektor (300) zum Erfassen von geladenen Teilchen (105), die von dem zu untersuchenden Objekt (600) ausgehen;
eine Laserquelle (200), die geeignet ist, einen Laserstrahl (201) zu emittieren, so dass der Strahl geladener Teilchen den Laserstrahl (201) schneidet und eine Wechselwirkung des Strahls geladener Teilchen (103) und des Laserstrahls (203) zu einer Modulation des Strahls geladener Teilchen führt,
wobei das Strahlmodulationselement (400) ein dielektrisches oder Halbleitermaterial umfasst,
wobei das Strahlmodulationselement (400) so positioniert ist, dass der Schnittpunkt des Strahls geladener Teilchen im Querschnitt des Strahlmodulationselements (400) liegt.

2. Überwachungsgerät für geladene Teilchen nach Anspruch 1, wobei das Strahlmodulationselement so angepasst ist, dass es weniger als 10%, weiter bevorzugt weniger als 1%, noch weiter bevorzugt weniger als 0,1% und am meisten bevorzugt weniger als 0,01% der Laserintensität absorbiert.

3. Überwachungsgerät für geladene Teilchen nach einem der vorhergehenden Ansprüche, wobei das Strahlmodulationselement (400) als Folie ausgebildet ist, die ein Dielektrikum oder ein Halbleitermaterial umfasst.

4. Überwachungsgerät für geladene Teilchen nach einem der vorhergehenden Ansprüche, wobei das Strahlmodulationsglied (400) eine Haltevorrichtung aufweist, die die Platte oder Folie hält.

5. Überwachungsgerät für geladene Teilchen nach Anspruch 3 oder 4, wobei die Folie mindestens ein Loch aufweist.

6. Überwachungsgerät für geladene Teilchen nach einem der vorhergehenden Ansprüche, wobei die Folie von der Haltevorrichtung gedehnt wird, während sie von der Haltevorrichtung in ihrer Form gehalten wird, oder wobei die Folie von der Haltevorrichtung in gedehnter Weise gehalten wird.

7. Überwachungsgerät für geladene Teilchen nach einem der Ansprüche 4 bis 12, wobei die Folie eine Mindestdicke von 1 nm bis 500 nm, vorzugsweise von 5 nm bis 250 nm, noch bevorzugter von 5 nm bis 125 nm und am meisten bevorzugt von 5 nm bis 80 nm aufweist.

8. Überwachungsgerät für geladene Teilchen nach einem der vorhergehenden Ansprüche, wobei der Laserstrahl (203) und der Strahl geladener Teilchen (103) von gegenüberliegenden Seiten des Strahlmodulationselements (400) oder der Folie auf das Strahlmodulationselement (400) einfallen.

9. Überwachungsgerät für geladene Teilchen nach einem der vorhergehenden Ansprüche, wobei die Wechselwirkung des Strahls geladener Teilchen (103) und des Laserstrahls (203) zu einer periodischen Beschleunigung der geladenen Teilchen an der Stelle der Wechselwirkung zwischen dem Laserstrahl und dem Strahl geladener Teilchen führt.

10. Überwachungsgerät für geladene Teilchen nach einem der vorhergehenden Ansprüche, wobei die elektromagnetische Wechselwirkung des Strahls geladener Teilchen (103) und des Laserstrahls (203) zu einer seitlichen Ablenkung zumindest eines Teils der geladenen Teilchen von der Hauptstrahlachse (110) führt.

11. Überwachungsgerät für geladene Teilchen gemäß einem der vorhergehenden Ansprüche, wobei eine Frequenzbandbreite der im Wesentlichen kontinuierlichen Laserquelle (200) kleiner als 10 GHz ist.

12. Überwachungsgerät für geladene Teilchen nach einem der vorhergehenden Ansprüche, wobei die Überwachungsvorrichtung ferner optische Elemente (205) zum Aufspalten des Laserstrahls (201) oder Mittel zum Erzeugen eines phasenstarren zweiten Laserstrahls und zum Leiten eines ersten Laserstrahls (203) auf das Strahlmodulationsglied (400) und eines zweiten Laserstrahls (223) auf ein zu untersuchendes Objekt (600), das von Haltemitteln gehalten wird, umfasst, wobei die optischen Elemente eine optische Phasenverschiebungseinrichtung (700) umfassen, die geeignet ist, die optische Phase des zweiten Laserstrahls (223) an der Position des zu untersuchenden Objekts in Bezug auf die optische Phase des ersten Laserstrahls (203) an dem Strahlmodulationselement zu verschieben.

13. Überwachungsgerät für geladene Teilchen nacheinem der vorhergehenden Ansprüche, wobei der Laser ein Single-Longitudinal-Mode-Laser ist.

14. Elektronenmikroskop, **dadurch gekennzeichnet, dass** dieses eine Überwachungsvorrichtung für geladene Teilchen gemäß einem der vorangehenden Ansprüche umfasst.

15. Verfahren zur zeitaufgelösten Überwachung von ultraschnellen Prozessen, wobei das Verfahren aufweist:
Emittieren eines Strahls geladener Teilchen (103) entlang einer Hauptstrahlachse (110) aus einer Quelle für geladene Teilchen (100);
Richten des Strahls geladener Teilchen (103) auf ein Strahlmodulationselement (400), das auf der Hauptstrahlachse (110) angeordnet ist, wobei das Strahlmodulationselement (400) ein dielektrisches oder Halbleitermaterial umfasst;
Richten des Strahls von geladenen Teilchen (103) auf ein zu untersuchendes Objekt (600);
Erfassen von geladenen Teilchen (103), die von dem zu untersuchenden Objekt (600) ausgehen;
Modulieren des Strahls geladener Teilchen (103) durch Leiten eines Laserstrahls (203) auf das Strahlmodulationselement (400), so dass sich der Strahl geladener Teilchen mit dem Laserstrahl schneidet und dadurch der Strahl geladener Teilchen (103) und der Laserstrahl (203) in Wechselwirkung treten und der Strahl geladener Teilchen moduliert wird.

## Revendications

1. Appareil de surveillance de particules chargées pour une surveillance à résolution temporelle de processus ultra rapides, l'appareil de surveillance comprenant :
une source de particules chargées (100) adaptée pour émettre un faisceau de particules chargées (103) le long d'un axe de faisceau principal (110) ;
un élément de modulation de faisceau (400) qui est agencé sur l'axe de faisceau principal (110) ;
un moyen de maintien ou de fourniture d'un objet (600) à examiner qui est agencé sur l'axe de faisceau principal (110) ;
un détecteur (300) pour détecter des particules chargées (105) qui émanent de l'objet à examiner (600) et qui est agencé sur l'axe de faisceau principal (110) ;
une source laser (200) adaptée pour émettre un faisceau laser (201) de telle sorte que le faisceau de particules chargées intersecte le faisceau laser (201) et une interaction entre le faisceau de particules chargées (103) et le faisceau laser (203) résulte en une modulation du faisceau de particules chargées,
dans lequel l'élément de modulation de faisceau (400) comprend un matériau diélectrique ou semi-conducteur,
dans lequel l'élément de modulation de faisceau (400) est positionné de telle sorte que le point d'intersection du faisceau de particules chargées se trouve dans la section transversale de l'élément de modulation de faisceau (400).

2. Appareil de surveillance de particules chargées selon la revendication 1, dans lequel l'élément de modulation de faisceau est adapté pour absorber moins de 10 %, de préférence encore moins de 1 %, de préférence encore moins de 0,1 %, et de manière préférée entre toutes moins de 0,01 % de l'intensité laser.

3. Appareil de surveillance de particules chargées selon l'une quelconque des revendications précédentes, dans lequel l'élément de modulation de faisceau (400) est formé comme une feuille qui comprend un matériau diélectrique ou semi-conducteur.

4. Appareil de surveillance de particules chargées selon l'une des revendications précédentes, dans lequel l'élément de modulation de faisceau (400) comprend un dispositif de maintien qui maintient la plaque ou la feuille.

5. Appareil de surveillance de particules chargées selon la revendication 3 à 4, dans lequel la feuille comporte au moins un trou.

6. Appareil de surveillance de particules chargées selon l'une des revendications précédentes, dans lequel la feuille est étirée par le dispositif de maintien alors que sa forme est maintenue par le dispositif de maintien, ou dans lequel la feuille est maintenue par le dispositif de maintien de manière étirée.

7. Appareil de surveillance de particules chargées selon l'une des revendications 4 à 12, dans lequel la feuille présente une épaisseur minimale de 1 nm à 500 nm, de préférence de 5 nm à 250 nm, de préférence encore de 5 nm à 125 nm, et de manière préférée entre toutes de 5 nm à 80 nm.

8. Appareil de surveillance de particules chargées selon l'une quelconque des revendications précédentes, dans lequel le faisceau laser (203) et le faisceau de particules chargées (103) sont dirigés vers l'élément de modulation de faisceau (400) depuis des côtés opposés de l'élément de modulation de faisceau (400) ou de la feuille.

9. Appareil de surveillance de particules chargées selon l'une quelconque des revendications précédentes, dans lequel l'interaction entre le faisceau de particules chargées (103) et le faisceau laser (203) résulte en une accélération périodique des particules chargées à la position d'interaction entre le faisceau laser et le faisceau de particules chargées.

10. Appareil de surveillance de particules chargées selon l'une quelconque des revendications précédentes, dans lequel l'interaction électromagnétique entre le faisceau de particules chargées (103) et le faisceau laser (203) résulte en une déflexion latérale d'au moins une fraction des particules chargées qui les éloigne de l'axe de faisceau principal (110).

11. Appareil de surveillance de particules chargées selon l'une quelconque des revendications précédentes, dans lequel une bande passante de fréquence de la source laser essentiellement continue (200) est inférieure à 10 GHz.

12. Appareil de surveillance de particules chargées selon l'une quelconque des revendications précédentes, l'appareil de surveillance comprenant en outre des éléments optiques (205) pour diviser le faisceau laser (201), ou un moyen pour produire un deuxième faisceau laser verrouillé en phase, et pour guider un premier faisceau laser (203) sur l'élément de modulation de faisceau (400) et un deuxième faisceau laser (223) sur un objet (600) à examiner et maintenu par un moyen de maintien, moyennant quoi les éléments optiques comprennent un moyen de déphasage optique (700) adapté pour décaler la phase optique du deuxième faisceau laser (223) à la position de l'objet à examiner par rapport à la phase optique du premier faisceau laser (203) sur l'élément de modulation de faisceau.

13. Appareil de surveillance de particules chargées selon l'une quelconque des revendications précédentes, dans lequel le laser est un laser à mode longitudinal unique.

14. Microscope électronique **caractérisé en ce qu'**il comprend un appareil de surveillance de particules chargées selon l'une quelconque des revendications précédentes.

15. Procédé de surveillance à résolution temporelle de processus ultra rapides, le procédé comprenant :
l'émission d'un faisceau de particules chargées (103) le long d'un axe de faisceau principal (110) à partir d'une source de particules chargées (100),
la direction du faisceau de particules chargées (103) sur un élément de modulation de faisceau (400) agencé sur l'axe de faisceau principal (110), dans lequel l'élément de modulation de faisceau (400) comprend un matériau diélectrique ou semi-conducteur ;
la direction du faisceau de particules chargées (103) sur un objet (600) à examiner ;
la détection de particules chargées (103) émanant de l'objet (600) à examiner ;
la modulation du faisceau de particules chargées (103) en guidant un faisceau laser (203) sur l'élément de modulation de faisceau (400) de telle sorte que le faisceau de particules chargées intersecte le faisceau laser et résulte par conséquent en une interaction entre le faisceau de particules chargées (103) et le faisceau laser (203) et en une modulation du faisceau de particules chargées.
